# EUROPEAN PATENT SPECIFICATION

(11) **EP 3 470 852 B1**
(45) Date of publication and mention of the grant of the patent: **21.08.2024**
(21) Application number: 17196233.5
(22) Date of filing: 12.10.2017
(51) Int. Cl.: G01R 13/02

(54) **MEASUREMENT APPARATUS AND METHOD FOR OPERATING A MEASUREMENT APPARATUS**
MESSVORRICHTUNG UND VERFAHREN ZUM BETRIEB EINER MESSVORRICHTUNG
APPAREIL DE MESURE ET PROCÉDÉ DE FONCTIONNEMENT D'UN APPAREIL DE MESURE

(43) Date of publication of application: 17.04.2019
(73) Proprietor: Rohde & Schwarz GmbH & Co. KG, 81671 München (DE)
(72) Inventor: Guenther, Mario, 08371 Glauchau (DE)
(74) Representative: Novagraaf Group

(56) References cited:
- US-A1- 2013 100 154
- US-A1- 2013 207 641
- US-B2- 7 366 993

## Description

### TECHNICAL FIELD

The present invention relates to a measurement apparatus for measuring electrical measurements. Further the present invention relates to a method for operating a measurement apparatus.

### BACKGROUND

Although applicable in principal to any electronic system providing data with units or prefixes, the present invention and its underlying problem will be hereinafter described in combination with a measurement device for measuring electric parameters.

In modern measurement devices many parameters can be measured. Usually at least some of these parameters related to different properties and thus, the measured parameters may have different units. For instance, a voltage is measured in units of volts (V), a current is measured in units of ampere (A), a frequency is measured in units of Hertz (Hz), etc.

Furthermore, the measurement devices usually have a wide range of measurement. Thus, very small values for the respective parameters may be measured in a first measurement, and the relative high value may be measured in second measurement. In order to facilitate the legibility of the displayed values, an appropriate prefix may be used. For example the prefix "m" (milli) may be used in order to represent a thousandth of the respective unit, and the prefix "k" (kilo) may be used in order to represent the thousand roof of a unit.

Even though these units are well known to an operator, it may be difficult for a system to recognize and consider the respective prefixes.

In addition, some parameters may be measured in different units. For example, a pressure may be measured in units of "Pascal", "bar" or "Psi". Thus, it is necessary to consider the respective unit when performing further operations with these data.

Especially when data are transferred from one system to another, it is necessary to consider the prefixes and the units of the parameters.

Against this background, the present invention aims to provide a versatile transfer of datasets between individual components or applications in a measurement device.

US 7 366 993 B2 describes a system and method for displaying signals. A first user input is received for requesting display of a first signal. A display tool displays the first signal. The signal comprises signal data, e.g., signal plot data.

### SUMMARY

The present invention provides a measurement apparatus with the features of the independent claims.

As explained above, the data related to the measurement apparatus, i.e. the measurement itself as well as the setup parameters and the further data like a scaling etc. may not only comprise a simple value, but also a unit and a prefix. The additional information is also part of the respective dataset and may be considered.

When multiple devices are communicatively coupled with each other, for instance by an interface, a data bus or the like, the respective information can be exchanged. However, when the data exchange is performed by displaying data on a display and entering the data on an input area of the display, the related prefixes and units may be separated from the respective values. For example, prefixes or units may be displayed next to an input field for inputting the value and the user usually have to take into account the displayed value. Thus, when transferring a value from one application to an input field of another application, the respective transfer operation has to consider the respective prefixes and units. For example, a first application may provide a datasets with a prefix of "milli" ("m"), while the other application deals with values considering a prefix of micro ("µ"). In another example, first application may deal with this dataset in a linear scale and another application may deal with dataset in a logarithm scale ("dB"). Thus, when transferring datasets from one application to another by displaying and entering the data on the display screen, the respective properties like prefix, scale and unit have to be taken into account.

The measurement device may be any kind of measurement device which can perform a measurement operation. For example, the measurement device may measure an electric parameter like a voltage, current, an electric or electromagnetic field, an intensity of radiation, a frequency, etc. However, it is understood that the measurement device of the present invention is not limited to the above-mentioned parameters. Moreover, any other kind of parameter can be also measured. In particular, it may be possible to measure one or more parameters over the predetermined time period, or within a predetermined bandwidth.

The result of the measurement may be directly displayed on the display or may be stored in a memory of the measurement device. In the latter case, the data stored in the memory may be read out and provided on the display upon request or based on a particular trigger event. Especially, when providing the measured parameter on the display, it is possible to display not only a value of the parameter, but also the corresponding unit, the prefix and any other kind of information related to the value of the measured parameter. For example, it may be also possible to display whether the displayed value relates to an averaged or a peak measurement, whether the values are acquired in a linear or a logarithm (dB) scale, etc. However, is understood, that any other information related to the displayed value may be also displayed in conjunction with the displayed value.

The additional information like prefix, unit, etc. may be displayed in a common field in an area of the display, i.e. on the predetermined area of the display which is used to display the value, the prefix and/or the unit in common. However, it may be also possible, that a first field is used for displaying the value of a dataset and closed to this first field the related other information like prefix or unit are displayed separately. Accordingly, when the measured value changes, it is only necessary to adapt the information in the first field related to the value, while the related prefix or unit are kept unchanged.

Accordingly, it may be possible to display a dataset by a first application on a predetermined position of the display and successively read out the displayed dataset by another application. In this way, the information of the dataset can be transferred from the first application to the other application without any interfaces or communication channels. By considering the value in combination with the prefix and the unit of the dataset, it is possible to consider all relevant information of the respective dataset.

For example, it is possible that the measurement device performs the measurement and displays the respective measurement result as a dataset comprising a value, prefix and unit on a predetermined display position. This dataset can be acquired by a further, independent application and thus, the dataset can be processed by the further application in any appropriate manner. For example, the dataset can be acquired by an application periodically in order to record a sequence of the measurements. Further, it may be also possible to acquire the displayed dataset in order to perform a further processing of the acquired dataset. For example, the displayed dataset may be acquired by a calculator application in order to perform an automated or at least semi-automated calculation using the dataset provided by the first application.

Further to the transfer of datasets related to a measurement, it may be also possible to apply exchange information of datasets, wherein the dataset comprises a value in combination with a prefix and/or a unit. For example, it may be also possible that a first application, for instance measurement device, displays datasets related to a present setting of the measurement device. For example, it may be possible to display a dataset related to a sample rate, a point of time when the measurement is performed, a period of time for the measurement, a range of the measurement, in particular a lower and/or upper limit, a bandwidth, or any other properties which may be set up or considered for performing a measurement. Accordingly, these datasets, which may be also displayed on the predetermined positions on the display by a measurement device, may be also acquired by a further application, for instance the processing device. In this way, the respective information of these datasets can be taken into account for a further analysis of the measurement data.

The datasets which are displayed on the display by the measurement device may relate to data of a current measurement. In other words, the displayed datasets may relate to real-time data. However, it may be also possible that the measurement device may store measurement data, and if appropriate any further data related to the measurements, in a memory of the measurement device. In this case, the stored data may be read out and displayed on the display. Accordingly, it is possible to display previously acquired measurement data and/or settings of the respective measurement process on the display and to transfer the respective datasets to a further application, in particular to the processing device.

Further to a transfer of information related to datasets provided by the measurement device to a processing device, it may be also possible to perform a transfer of information in the reverse direction. In this case, an application, for instance the data processing device may acquire a dataset and enter the data of this dataset at an input area on the display which is used by the measurement device for receiving data. For example, the data processing device may acquire data for setting up the measurement device and enter the respective data as datasets on the areas of the display which are used by the measurement device for receiving the respective settings. An example, a measurement range, an upper and/or lower limit, a sampling rate, a time period for a measurement or any other appropriate setting for setting up the measurement device may be possible. Especially, it may be possible that the datasets which are entered by the processing device at the respective areas on the display comprise values in combination with a prefix and/or a unit. Furthermore, it may be also possible that the measurement device provides an input area having a predetermined setting for the prefix and/or a unit. In this case, the data processing device may acquire the respective displayed setting for the prefix and/or the unit and adapt the value of the datasets according to the requirements specified by the prefix and/or the unit which are displayed by the measurement device.

The data processing device may perform an automatic setup of the measurement device by entering the respective datasets on the corresponding position on the display. For example, the data processing device may receive instructions for setting up the measurement device to a predetermined configuration. A number of one or more predetermined configurations may be stored in a memory of the data processing device. Accordingly, the data processing device may read out the respective configuration and enter the datasets of this configuration on the appropriate positions on the display. Especially, the datasets may comprise not only a value, but also a prefix and/or a unit.

Furthermore, the processing device may also perform the processing of the dataset before entering the respective dataset on the display. For example, the processing device may receive a number of one or more values or a dataset comprising a value and a prefix and/or a unit; and the processing device may apply one or more computational operations to the received value or the dataset before entering the processed dataset on the respective position of the display. The processing of the dataset by the processing device may comprise a computation operation, a conversion of the unit in the dataset, or any other appropriate operation.

Furthermore, it is also possible to acquire information from the measurement device by the data processing device, perform a number of one or more computational operations and subsequently enter a number of one or more datasets on input areas of the measurement device on the display. For example, the data processing device may acquire a present measurement, analyze the present measurement and subsequently adapt a number of one or more parameters of the measurement device. For example, if the data processing device acquired the present measurement and recognizes that the measurement comes close to particular limitation, the data processing device may automatically determine appropriate settings in order to adapt the measurement device accordingly. However, it is understood, that the transfer of datasets and the processing of the data by the data processing device is not limited to the above mentioned examples. Moreover, any other operation for transferring datasets from the measurement device to the data processing device and/or from the data processing device to the measurement device may be possible, too.

In order to acquire a dataset by the data processing device which is displayed by the measurement device, the data processing device reads out a display memory of the display.

Accordingly, it may be also possible to apply any appropriate scheme in the other direction to enter datasets from the data processing device to input areas related to the measurement device. For example, the data processing device may provide information of a dataset to the display memory of the display.

The measurement device may comprise hardware elements, like e.g. a processing unit. However, the measurement device may also be software implemented at least in part. First instructions may therefore be stored in a memory that is coupled to a general purpose processor, e.g. via a memory bus. The processor may further execute an operating system that loads and executes the first instructions. The processor may e.g. be an Intel processor that runs a Windows or Linux operating system that loads and executes the first instructions. In another embodiment, the processor may be a processor of a measurement device that may e.g. run an embedded operating system that loads and executes the first instructions.

The processing device may comprise hardware elements, like e.g. a processing unit. However, the signal processor may also be software implemented at least in part. Second instructions may therefore be stored in a memory that is coupled to a general purpose processor, e.g. via a memory bus. The processor may further execute an operating system that loads and executes the second instructions. The processor may e.g. be an Intel processor that runs a Windows or Linux operating system that loads and executes the second instructions. In another embodiment, the processor may be a processor of a measurement device that may e.g. run an embedded operating system that loads and executes the second instructions.

It is understood, that a single computer or processor may load and execute the first instructions and the second instructions.

Further embodiments of the present invention are subject of the further subclaims and of the following description, referring to the drawings.

In a possible embodiment, the dataset comprises a value, a prefix and/or a unit.

The value may be a plain number like an integer number or a floating point number. In other words, the value may comprise a number of one or more digits and, if necessary, a decimal point or comma. Further, the value may be also represented in any other appropriate format, for instance as an exponential number or the like. A prefix, also known as unit prefix, is a specifier or mnemonic that is prepended to units of measurement to indicate multiples or fractions of the units. Units of various sizes are commonly formed by the use of such prefixes. The prefixes of the metric system, such as kilo and milli, represent multiplication by powers of ten. Usually, a single capital or small letter is used for indicating the respective multiplier. Units usually relate to specific physical quantities. For example, a voltage may be specified in a unit of volts (V), current may be specified in units of ampere (A), etc. Even though there exist recommendations for many physical properties, some physical properties may be described by a plurality of different units. For example, a length may be specified in units of meters, inches, etc. Accordingly, the temperature may be specified in degrees of Celsius, Fahrenheit or in Kelvin. A pressure may be measured in units of Pascal, bar, Psi, etc. Any other kind of unit may be assigned to a dataset depending on the measured physical value.

In a possible embodiment the processing device is adapted to separate the dataset into the value, the prefix and/or the unit.

Accordingly, the processing device may acquire a dataset comprising not only a value, but also at least a prefix or a unit. Accordingly, for a further processing of the acquired dataset, the processing device may identify the assigned prefix and/or the respective unit. Accordingly, the data processing can be adapted to the properties which are specified by the prefix or the unit in conjunction with the value of the dataset.

In a possible embodiment, the processing device is adapted to perform a conversion of the prefix and/or the unit and/or to perform an operation with a dataset having a further unit and/or prefix.

As already mentioned above, same physical properties may be specified by a plurality of different units. Accordingly, a value of the dataset may be converted to an appropriate unit for further processing. Furthermore, prefixes may be also considered for adapting the value of an acquired dataset. For example, the acquired value may be multiplied with a multiplier corresponding to the prefix. Accordingly, a conversion between units may be performed by applying an appropriate conversion formula or algorithm for converting a value provided in the first unit to a value related to another unit.

In a possible embodiment the processing device is adapted to assign a prefix and/or a unit to a value of the acquired dataset or the acquired further dataset.

In some circumstances it may be possible that provided dataset only comprises a value. In this case, it may be assumed that the value relates to a predetermined well known unit and/or a well-known predetermined prefix. In order to adapt such a value for a further processing, it may be possible to assign this well-known predetermined prefix and/or unit to an acquired value to obtain a complete dataset. For example, if the measurement device always outputs only values related to a particular unit, or at least to a particular physical property, the corresponding unit may be not specified on the display when outputting the value. In this case, the data processing device may automatically assign the respective unit to the acquired value in order to obtain complete dataset.

In a possible embodiment the processing device is adapted to automatically identify a dataset on the display which is displayed by the measurement device.

For example, the processing device may search in the whole display for positions which may comprise a dataset. Even though the preceding and the following description relates to a display as a whole, the measurement data and the further data relating to the measurement device may be displayed on a particular window within the display. Furthermore, a separate window on the display may be used for displaying data related with the processing device. The processing device may scan the information on the display for appropriate properties. For instance, the processing device may recognize particular keywords, e.g. "result", "voltage", "current", "input", "output", etc. It is understood that the search for appropriate positions of datasets is not limited to such a search of the above-mentioned keywords. Moreover any other keywords may be used or any other team for identifying an appropriate position of an input or output field may also possible.

In a possible embodiment, the processing device is adapted to acquire datasets from a plurality of predetermined positions on the display and/or enter datasets to a plurality of predetermined positions on the display.

There may be, for example a plurality of areas on the display on which the measurement device may display measurement results, settings of the measurement device, or other data related with the measurement performed by the measurement device. Accordingly, the processing device may acquire at least one, multiple or even all data provided by the measurement device on the display. For example, the processing device may identify the areas of interest for acquiring one or multiple datasets. For this purpose, the processing device may analyze the individual areas in order to identify an appropriate area for providing a dataset. In particular, it may be possible that the processing device recognize the keyword in front of the respective area in order to determine the content of the dataset in the respective area. However, it is understood that any other process for identifying areas comprising datasets on the display may be possible, too.

In a possible embodiment the processing device is adapted to a highlight the dataset on the predetermined position of the display.

The highlighting of the dataset may be performed, for instance by changing the color of the respective area, drawing a rectangle surrounding the respective area, inverting the respective area or any other possibility for highlighting the respective area. Further, it may be also possible to apply a flashing on the respective area in order to easily recognize the identified areas of interest on the display. In this way, the areas which are acquired by the processing device can be easily recognized and thus, a user may verify or confirm the operation of the processing device.

In a possible embodiment the dataset relates to a measurement of the measurement device, a parameter for setting up the measurement device and/or a scale related to the measurement of the measurement device.

By acquiring the datasets relating to the measurement, the data processing device can easily obtain the measurement data. Since not only the numerical value of the measurement is acquired, but also the prefix and/or the unit, it is possible to obtain all relevant information of the measurement. In particular, the processing device can recognize if the prefix is changing and the processing of the acquired dataset by the processing device can consider a correct factor depending on the respective prefix. Furthermore, the data processing device can recognize the respective physical parameter by analyzing the unit. For example, if the data processing device identifies the unit, the data processing device can identify the corresponding physical parameter. Thus, data processing device can easily differentiate between the individual physical parameters, for instance a voltage, current, frequency, intensity, time period, etc. In this way, the processing of the data processing device can be adapted accordingly.

Further, if the dataset relates to parameter for setting up the measurement device, the data processing device can easily recognize the setting of the measurement device by acquiring the settings which are displayed by the measurement device on the display. On the other hand, the processing device may enter appropriate data sets on input areas which are used for setting up the measurement device. In this way, it is possible to automatically set up the measurement device by the processing device.

By analyzing the scale which is displayed by the measurement device on an appropriate area on the display, the processing device can easily adapt the processing to the provided scale. On the other hand, if the processing device enters an appropriate scale on an input area which is used by the measurement device, the processing device can easily set up the scale on the measurement device.

In a possible embodiment, the dataset relates to a currently measured value or to a stored previously measured value.

By displaying a currently measured value in combination with the corresponding prefix and/or unit and acquiring the displayed dataset by the processing device, it is possible to perform an almost real-time data exchange between the measurement device and the processing device. In particular, it is possible to acquire the measurement data immediately upon the respective data are displayed on the display by the measurement device. In this case, it is not necessary to perform any intermediate storage of the respective dataset.

Furthermore, it is also possible to use a memory for storing measured data and/or further data related to the measured data. In this case, the respective data can be read out from the memory and displayed on the display at a later point of time. Accordingly, it is even possible to exchange data between the measurement device and the processing device at an arbitrary point of time later than the time for measuring the respective data.

In a possible embodiment, the display comprises a touchscreen. Further, the display may comprise any other kind of display screen, for instance using LED or LCD technology.

If the display comprises a touchscreen, the touchscreen may be also used for further interaction with the user. For instance, the user may enter further commands, for controlling the operation of the data exchange between the measurement device and the processing device. For instance, the user may specify respective area on display on which the dataset is displayed and which can be acquired. Furthermore, it may also possible that the user may initiate a particular operation, and based on this operation, and automated data transfer between the measurement device and the processing device is started. For example, the user may select a particular set up and based on this selected setup, the processing device automatically enters the appropriate parameters for setting up the measurement device on the respective input areas of the display used by the measurement device. Furthermore, it may also possible, that user may select an automated data acquisition, and based on this selected operation, the processing device automatically acquires the measurement data displayed by the measurement device on a respective area of the display at predetermined points of time, especially in the periodic manner. However, it is understood, that any other operation may be initiated by a user interaction.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a block diagram of an embodiment of a measurement apparatus according to the present invention;
- Fig. 2: shows an example of a display according to the present invention;
- Fig. 3: shows a block diagram of an embodiment of a method according to the present invention; and
- Fig. 4: shows a block diagram of an embodiment of a further method according to the present invention.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

### DETAILED DESCRIPTION OF THE DRAWINGS

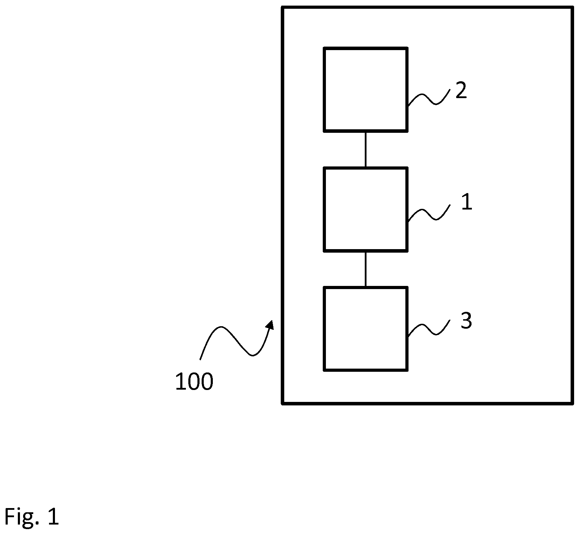

Fig. 1 shows as a schematic drawing of a measurement apparatus 100 according to an embodiment. The measurement apparatus 100 comprises a display 1, a measurement device 2 and a processing device 3. The measurement device 1 may perform any kind of measurement, in particular any kind of measuring an electric parameter such as a voltage, a current, an electric or electromagnetic field, a frequency, a frequency spectrum, etc. However, any other kind of parameter may be also measured by measurement device 2.

The result of measurement performed by measurement device 2 may be displayed on display 1. For example, display 1 may be screen like an LCD or LED display. Especially, display 1 may be a touchscreen which may be used for displaying information and for receiving input from the user. For example, measurement device 2 may open a window on a display like a computer screen for displaying the information related to with the result of the measurement. Furthermore, the present settings of the measurement device 2 may be also displayed on the display 1, especially on the window related to the measurement device 2. Additionally, there may be a number of one or more input areas on the display 1, especially on the window related to the measurement device 2, on which parameters for setting up the measurement device 2 to may be entered. For example, it may be possible to enter a sensitivity parameter, a sampling rate, a bandwidth or any other parameter for setting up the measurement device 2.

In this way, the information related to a measurement by the measurement device 2 may be displayed on display 1. Accordingly, a user can read the measurement results and enter setup parameters for setting up the measurement device 2.

Furthermore, the measurement apparatus 100 may comprise a processing device 3. Processing device 3 may be any kind of device or computer application for processing data. For instance, processing device 3 may provide a computing application for performing computations like mathematical operations. Accordingly, a user may enter a number and perform a mathematical operation by means of processing device 3. For this purpose, the input and output operations may be also performed by display 1. If appropriate or necessary, a further input device (not shown) may be also provided for receiving user input. If the display 1 comprises touchscreen, input and output operations may be performed by display 1.

Especially, display 1 may also display the data related with processing device 3. In particular, a separate window may be provided on display 1 for the data related with processing device 3. Even though this embodiment is described in connection with a processing device 3 providing a mathematical operation, any other kind of application may be provided by processing device 3, too.

In order to perform a mathematical operation by an application provided by processing device 3 which is based on the data are provided by measurement device 2, the data provided by measurement device 2 on the display have to be copied to the respective input areas on the display 1 which relate to the processing device 3.

Since measurement device 2 usually deals with physical parameters, these parameters comprise not only a simple numerical value, but also a physical unit and a prefix for scaling the value of the measurement. Accordingly, all this information have to be taken into account when copying the data from the image area related to the measurement device 2 to an input area on the display 1 which relates to the processing devices 3. For this purpose, it may be possible to select the numerical value together with the physical unit and a prefix and combine in this information to a common dataset. The combined dataset which comprises the numerical value, the prefix and the physical unit may be copied from the display area of the measurement device 2 to an input area on a display 1 which relates to the processing device 3. In this way, it is possible to automatically transfer the information of the dataset comprising the numerical value together with the prefix and the physical unit from the display area related to the measurement device 2 and display area related to the processing device 3. In this way, the processing devices 3 may perform any operation like numerical processing based on the whole dataset including the prefix and the physical unit.

For example, the processing devices 3 may perform a conversion of the transferred dataset from one physical unit to another physical unit, a multiplication with another dataset comprising a numerical value and a physical unit, or any other appropriate operation.

In the above-described example, a dataset comprising a numerical value together with a prefix and a physical unit is copied from a display area related to the measurement device 2 to an area of the display 1 which relates to the processing device 3. However, it may be also possible to transfer a dataset with a numerical value, a prefix and a physical unit from a display area relating to the processing device 3 to a display area relating to the measurement device 2.

For example, processing device 3 may display a number of one or more appropriate parameters for setting up the measurement device 2. Accordingly, one or more of these display parameters may be selected and the selected parameters comprising numerical value together with prefix and the physical unit may be copied to an input area of the display 1 relating to the measurement device 2.

The parameters for setting up the measurement device 2 which are provided by the processing device 3 may be stored in a memory (not shown) in advance and may be provided on the display 1 upon request. However, any other operation for providing datasets comprising a numerical value and a physical unit may be possible, too. For example, it is also possible that a user enters some input data, for instance a numerical value, on an input area relating to the processing devices 3 and processing device 3 performed some computations using the input data. Subsequently, the result of the processing device 3 may be copied to an input area of the measurement device 2. In this case, it is also possible to copy the dataset comprising the numerical value together with prefix and physical unit.

Furthermore, it may be even possible to select a dataset on an image area relating to measurement device 2 and copy in this dataset to an input area of processing device 3. Processing devices 3 may perform any computations using the copied dataset, and subsequently, the result of the computation by processing devices 3 may be displayed on the display 1. In this case, the displayed result of processing devices 3 may be copied from an image area relating to processing device 3 to an image area relating to measurement device 2, wherein the copying comprises a copying of a whole dataset including a numerical value together with a prefix and the physical unit.

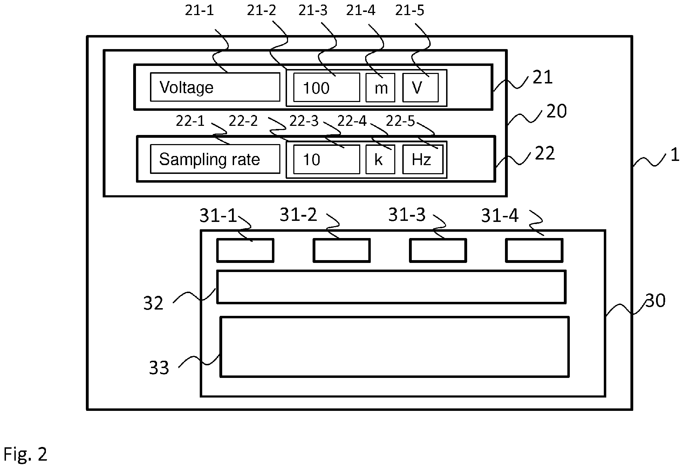

Fig. 2 shows an exemplary representation of a display 1. In this example, display 1 provides a first display area 20 relating to measurement device 2. Further, display 1 provides a second display area 30 which relates to processing devices 3. In this example, the first display area 20 comprises a first element 21 relating to a measurement result. The first element 21 comprises a description 21-1 which specifies the measurement, in this example a voltage. Further, the first element 21 comprises a dataset 21-2 with the measurement result. This dataset 21-2 comprises a numerical value 21-3, a prefix 21-4 and a physical unit 21-5. The first display area 20 further comprises a second display element 22 relating to setup parameter, in this case a sampling rate. The second display element 22 comprises a description 22-1 and a dataset 22-2 for specifying the respective parameters. The dataset relating to the second display element 22 comprises a numerical value 22-3, a prefix 22-4 and a physical value 22-5. However, it is understood, that the present invention is not limited to displaying only a single measurement value and/or obtaining only a single setup parameter. Moreover, any number of one or more measurement datasets and/or setup parameters may be also possible.

The image area of display 1 may further comprise a second image area 30 relating to the processing device 3. For instance, the second image area 30 may provide an application for processing data. In particular, the application may be, but not limited to, a calculator application. Accordingly, it may be possible to enter input data like a value or a dataset comprising a value in combination with a prefix and/or a physical unit, and to perform mathematical operations based on the input data.

For example, the second image area 30 relating to the processing device 3 may comprise an input/output area 32, and a further area 33 for providing a keypad or similar functions. Accordingly, by operating the keypad, it is possible to perform appropriate operations like mathematical computations. Furthermore, the second image area 30 may comprise some additional functional keys 31-i. These function keys may provide automated operations for copying a dataset from the first image area 20 to an input area 32 of the second image area 30. For example, the first key 31-1 may copy only a numerical value from the first image area 20 to the input area 32 of the second image area 30. A second key 31-2 may copy a whole dataset comprising the numerical value together with prefix and physical unit from the first image area 20 to the input area 32 of the image area 30.

After performing a processing by processing device 2, a result may be displayed on the input/output area 32 of the second image area 30. Accordingly, a third operation key 31-3 may copy the numerical value displayed on the input/output area 32 of the second image area 30 to an input area of the first image area 20. A fourth operation key 31-4 may copy a dataset comprising the numerical value together with prefix and a physical unit from the input/output area 32 of the second image area 30 to an input area of the first image area 20.

However, the present invention is not limited to the above-described for operation keys 31-i. It may be possible, to provide other or further operation keys with additional functionalities. For example, if the first image area 20 provides more than one areas for displaying or entering data, it may be possible to automatically identify the respective areas on the first image area 20. For example, an additional operation keys may be provided for performing such an automated identification. A further operation key may be provided for selecting a particular input or output area on the first image area 20, or for selecting all available areas together. However, it is understood that the present invention is not limited to the above described operations for copying or selecting datasets. Furthermore, it is also possible to provide any other functionality for copying or selecting datasets comprising values together with a prefix and/or a physical unit.

It is also possible that the second image area 30 relating to the processing devices 3 provides functionality for providing a plurality of setup parameters and for selecting a particular set of parameters. Accordingly, after selecting appropriate setup parameters, the selected setup parameters may be automatically copied from the third image area 30 to the second image area 20 automatically. In particular, it is possible to copy the selected setup parameters comprising a dataset of a numerical value, a prefix and a physical unit.

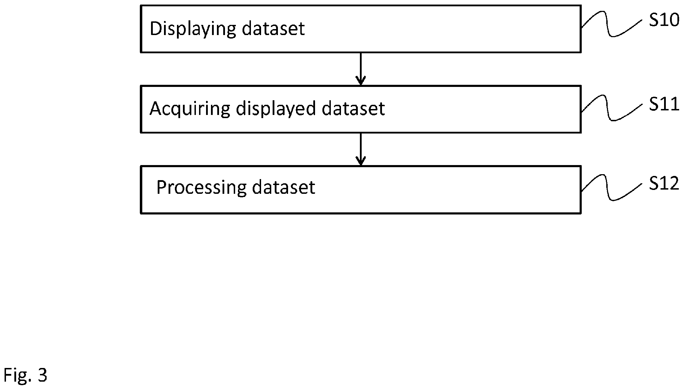

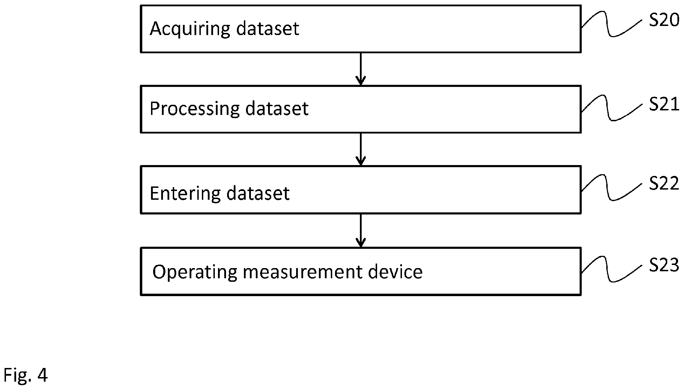

For sake of clarity in the following description of the methods based on Figs. 3 and 4 the reference signs used above in the description of apparatus based Figs. 1 and 2 will be maintained.

Fig. 3 shows a block diagram of a method for operating a measurement apparatus 100 as described above. In step S10 a first dataset is displayed, the first dataset is related to a measurement on a predetermined position on a display 1 by a measurement device 2. In step S11 the first dataset displayed on the predetermined position of the display 1 is acquired by the processing device 3. In step S12 the acquired first dataset is processed by the processing device 3.

The method may further comprise a step of automatically identifying the predetermined position on the display 1 on which the first dataset is displayed by the measurement device 2.

Fig. 4 shows a block diagram of a further method for operating a measurement apparatus 100 as described above. The method comprises the step S20 for acquiring a second dataset by the processing device 3. In step S21 the acquired second dataset is processed by the processing device 2. In a step S22 the processed second dataset is entered on the predetermined position of the display 1 by a processing device 2. In step S23 the measurement device 3 is operated based on the entered processed second dataset.

The method may further comprise a step of assigning a prefix and/or a unit to the processed second dataset.

Summarizing, the present invention provides an enhanced transfer of data between image areas on a display. In particular, it is possible to acquire a dataset comprising a numerical value together with a prefix and/or physical unit. Accordingly, the whole dataset comprising the numerical value, the prefix and the physical unit can be automatically copied from one image area to another. In this way, it is possible to transfer the information of the respective dataset between different applications running on a common display.

In the foregoing detailed description, various features are grouped together in one or more examples or examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects.

### List of reference signs

- 1: display
- 2: measurement device
- 3: processing device

- 20, 30: image areas
- 21, 22, 31, 32, 33: image elements

- 100: measurement apparatus

- S10, S11, S12, S20, s21, S22, S23: method steps

## Claims

1. A measurement apparatus (100) for measuring electrical measurements, comprising:
a display (1);
a measurement device (2) adapted to display a dataset related to a measurement on a predetermined position on the display (1), and acquire a dataset related to the measurement which is entered on the predetermined position on the display (1); and
a processing device (3) adapted to acquire the dataset displayed on the predetermined position of the display (1) by the measurement device (2) and process the acquired dataset,
**characterised in that** the data processing (3) device is adapted to read out a display memory of the display in order to acquire the dataset displayed by the measurement device (2).

2. The measurement apparatus (100) according to claim 1, wherein the dataset comprises a value, a prefix and/or a unit.

3. The measurement apparatus (100) according to claim 2, wherein the processing device (3) is adapted to separate the dataset into value, prefix and/or unit.

4. The measurement apparatus (100) according to claim 2 or 3, wherein the processing device (3) is adapted to perform a conversion of the prefix and/or the unit and/or to perform an operation with a dataset having a further unit and/or prefix.

5. The measurement apparatus (100) according to any of claims 1 to 4, wherein the processing device (3) is adapted to assign a prefix and/or a unit to a value of the acquired dataset or the acquired further dataset.

6. The measurement apparatus (100) according to any of claims 1 to 5, wherein the processing device (3) is adapted to automatically identify a dataset on the display which is displayed by the measurement device (2).

7. The measurement apparatus (100) according to any of claims 1 to 6, wherein the processing device (2) is adapted to acquire datasets from a plurality of predetermined positions on the display (1) and/or enter datasets to a plurality of predetermined positions on the display (1).

8. The measurement apparatus (100) according to any of claims 1 to 7, wherein the processing device (3) is adapted to a highlight the dataset on the predetermined position of the display (1).

9. The measurement apparatus (100) according to any of claims 1 to 8, wherein the dataset relates to a measurement of the measurement device (2), a parameter for setting up the measurement device (2) and/or a scale related to the measurement of the measurement device (2).

10. The measurement apparatus (100) according to any of claims 1 to 9, wherein the dataset relates to a currently measured value or to a stored previously measured value.

11. The measurement apparatus (100) according to any of claims 1 to 10, wherein the display (1) comprises a touchscreen.

12. A method for operating a measurement apparatus (100), comprising the steps of:
displaying (S10) a first dataset related to a measurement on a predetermined position on a display (1) by a measurement device (2);
acquiring (S11) the first dataset displayed on the predetermined position of the display (1) by reading out a display memory of the display (1) by the processing device (3); and
processing (S12) the acquired first dataset by the processing device (3).

13. The method according to claim 12, further comprising a step of automatically identifying the predetermined position on the display (1) on which the first dataset is displayed by the measurement device (2).

14. A method for operating a measurement apparatus (100), comprising the steps of:
acquiring (S20) a second dataset by reading out a display memory of a display (1) of a measurement device (2) by a processing device (3);
processing (S21) the acquired second dataset by the processing device (3);
entering (S22) the processed second dataset on the predetermined position of the display (1) by the processing device (3); and
operating (S23) the measurement device (2) based on the entered processed second dataset.

15. The method according to claim 14, wherein the method further comprises a step of assigning a prefix and/or a unit to the processed second dataset.

## Patentansprüche

1. Messeinrichtung (100) zum Messen elektrischer Messungen, umfassend:
eine Anzeige (1);
eine Messvorrichtung (2), die angepasst ist, um einen Datensatz in Bezug auf eine Messung an einer zuvor bestimmten Position auf der Anzeige (1) anzuzeigen und einen Datensatz in Bezug auf die Messung zu erfassen, der an der zuvor bestimmten Position auf der Anzeige (1) eingegeben wird; und
eine Verarbeitungsvorrichtung (3), die angepasst ist, um den Datensatz zu erfassen, der an der zuvor bestimmten Position der Anzeige (1) durch die Messvorrichtung (2) angezeigt wird und den erfassten Datensatz zu verarbeiten, **dadurch gekennzeichnet, dass**
die Datenverarbeitungsvorrichtung (3) angepasst ist, um einen Anzeigespeicher der Anzeige auszulesen, um den Datensatz zu erfassen, der durch die Messvorrichtung (2) angezeigt wird.

2. Messeinrichtung (100) nach Anspruch 1, wobei der Datensatz einen Wert, ein Präfix und/oder eine Einheit umfasst.

3. Messeinrichtung (100) nach Anspruch 2, wobei die Verarbeitungsvorrichtung (3) angepasst ist, um den Datensatz in Wert, Präfix und/oder Einheit zu trennen.

4. Messeinrichtung (100) nach Anspruch 2 oder 3, wobei die Verarbeitungsvorrichtung (3) angepasst ist, um eine Konvertierung des Präfixes und/oder der Einheit durchzuführen und/oder eine Operation mit einem Datensatz durchzuführen, der eine weitere Einheit und/oder ein weiteres Präfix aufweist.

5. Messeinrichtung (100) nach einem der Ansprüche 1 bis 4, wobei die Verarbeitungsvorrichtung (3) angepasst ist, um einem Wert des erfassten Datensatzes oder des erfassten weiteren Datensatzes ein Präfix und/oder eine Einheit zuzuweisen.

6. Messeinrichtung (100) nach einem der Ansprüche 1 bis 5, wobei die Verarbeitungsvorrichtung (3) angepasst ist, um einen Datensatz auf der Anzeige automatisch zu identifizieren, der durch die Messvorrichtung (2) angezeigt wird.

7. Messeinrichtung (100) nach einem der Ansprüche 1 bis 6, wobei die Verarbeitungsvorrichtung (2) angepasst ist, um Datensätze von einer Vielzahl von zuvor bestimmten Positionen auf der Anzeige (1) zu erfassen und/oder Datensätze an einer Vielzahl von zuvor bestimmten Positionen auf der Anzeige (1) einzugeben.

8. Messeinrichtung (100) nach einem der Ansprüche 1 bis 7, wobei die Verarbeitungsvorrichtung (3) angepasst ist, um den Datensatz an der zuvor bestimmten Position der Anzeige (1) hervorzuheben.

9. Messeinrichtung (100) nach einem der Ansprüche 1 bis 8, wobei sich der Datensatz auf eine Messung der Messvorrichtung (2), einen Parameter zum Einrichten der Messvorrichtung (2) und/oder eine Skala in Bezug auf die Messung der Messvorrichtung (2) bezieht.

10. Messeinrichtung (100) nach einem der Ansprüche 1 bis 9, wobei sich der Datensatz auf einen aktuell gemessenen Wert oder auf einen gespeicherten zuvor gemessenen Wert bezieht.

11. Messeinrichtung (100) nach einem der Ansprüche 1 bis 10, wobei die Anzeige (1) einen Berührungsbildschirm umfasst.

12. Verfahren zum Betreiben einer Messvorrichtung (100), umfassend die Schritte:
Anzeigen (S10) eines ersten Datensatzes in Bezug auf eine Messung an einer zuvor bestimmten Position auf einer Anzeige (1) durch eine Messvorrichtung (2);
Erfassen (S11) des ersten Datensatzes, der an der zuvor bestimmten Position der Anzeige (1) angezeigt wird, durch das Auslesen eines Anzeigespeichers der Anzeige (1) durch die Verarbeitungsvorrichtung (3); und
Verarbeiten (S12) des erfassten ersten Datensatzes durch die Verarbeitungsvorrichtung (3).

13. Verfahren nach Anspruch 12, ferner umfassend einen Schritt zum automatischen Identifizieren der zuvor bestimmten Position auf der Anzeige (1), auf der der erste Datensatz durch die Messvorrichtung (2) angezeigt wird.

14. Verfahren zum Betreiben einer Messvorrichtung (100), umfassend die Schritte:
Erfassen (S20) eines zweiten Datensatzes durch das Auslesen eines Anzeigespeichers einer Anzeige (1) einer Messvorrichtung (2) durch eine Verarbeitungsvorrichtung (3);
Verarbeiten (S21) des erfassten zweiten Datensatzes durch die Verarbeitungsvorrichtung (3);
Eingeben (S22) des verarbeiteten zweiten Datensatzes an der zuvor bestimmten Position der Anzeige (1) durch die Verarbeitungsvorrichtung (3); und
Bedienen (S23) der Messvorrichtung (2) basierend auf dem eingegebenen verarbeiteten zweiten Datensatz.

15. Verfahren nach Anspruch 14, wobei das Verfahren ferner einen Schritt des Zuweisens eines Präfixes und/oder einer Einheit zu dem verarbeiteten zweiten Datensatz umfasst.

## Revendications

1. Appareil de mesure (100) destiné à effectuer des mesures électriques, comprenant :
un affichage (1) ;
un dispositif de mesure (2) permettant d'afficher un ensemble de données relatif à une mesure sur une position prédéterminée de l'affichage (1), et d'obtenir un ensemble de données relatif à la mesure qui est saisie sur la position prédéterminée de l'affichage (1) ; et
un dispositif de traitement (3) permettant d'obtenir l'ensemble de données affiché sur la position prédéterminée de l'affichage (1) par le dispositif de mesure (2) et de traiter l'ensemble de données obtenu, **caractérisé en ce que**
le dispositif de traitement des données (3) est conçu pour lire une mémoire d'affichage de l'affichage afin d'obtenir l'ensemble de données affiché par le dispositif de mesure (2).

2. Appareil de mesure (100) selon la revendication 1, dans lequel l'ensemble de données comprend une valeur, un préfixe et/ou une unité.

3. Appareil de mesure (100) selon la revendication 2, dans lequel le dispositif de traitement (3) est conçu pour séparer l'ensemble de données en valeur, préfixe et/ou unité.

4. Appareil de mesure (100) selon la revendication 2 ou 3, dans lequel le dispositif de traitement (3) est conçu pour effectuer une conversion du préfixe et/ou de l'unité et/ou pour effectuer une opération avec un ensemble de données ayant une autre unité et/ou un autre préfixe.

5. Appareil de mesure (100) selon l'une quelconque des revendications 1 à 4, dans lequel le dispositif de traitement (3) est conçu pour attribuer un préfixe et/ou une unité à une valeur de l'ensemble de données obtenu ou de l'autre ensemble de données obtenu.

6. Appareil de mesure (100) selon l'une quelconque des revendications 1 à 5, dans lequel le dispositif de traitement (3) est conçu pour identifier automatiquement un ensemble de données sur l'affichage qui est affiché par le dispositif de mesure (2).

7. Appareil de mesure (100) selon l'une des revendications 1 à 6, dans lequel le dispositif de traitement (2) conçu pour obtenir des ensembles de données à partir d'une pluralité de positions prédéterminées sur l'affichage (1) et/ou pour entrer des ensembles de données dans une pluralité de positions prédéterminées sur l'affichage (1).

8. Appareil de mesure (100) selon l'une quelconque des revendications 1 à 7, dans lequel le dispositif de traitement (3) conçu pour mettre en évidence l'ensemble de données sur la position prédéterminée de l'affichage (1).

9. Appareil de mesure (100) selon l'une quelconque des revendications 1 à 8, dans lequel l'ensemble de données se rapporte à une mesure du dispositif de mesure (2), un paramètre de réglage du dispositif de mesure (2) et/ou une échelle relative à la mesure du dispositif de mesure (2).

10. Appareil de mesure (100) selon l'une quelconque des revendications 1 à 9, dans lequel l'ensemble de données se rapporte à une valeur actuellement mesurée ou à une valeur mesurée antérieurement stockée.

11. Appareil de mesure (100) selon l'une quelconque des revendications 1 à 10, dans lequel l'affichage (1) comprend un écran tactile.

12. Procédé de fonctionnement d'un appareil de mesure (100), comprenant les étapes consistant à :
afficher (S10) un premier ensemble de données relatif à une mesure sur une position prédéterminée sur un affichage (1) par un dispositif de mesure (2) ;
obtenir (S11) le premier ensemble de données affiché sur la position prédéterminée de l'affichage (1) en lisant une mémoire d'affichage de l'affichage (1) par le dispositif de traitement (3) ; et
traiter (S12) le premier ensemble de données obtenu par le dispositif de traitement (3).

13. Procédé selon la revendication 12, comprenant en outre une étape d'identification automatique de la position prédéterminée sur l'affichage (1) sur lequel le premier ensemble de données est affiché par le dispositif de mesure (2).

14. Procédé de fonctionnement d'un appareil de mesure (100), comprenant les étapes consistant à :
obtenir (S20) un second ensemble de données en lisant une mémoire d'affichage d'un affichage (1) d'un dispositif de mesure (2) à l'aide d'un dispositif de traitement (3) ;
traiter (S21) le second ensemble de données obtenu à l'aide du dispositif de traitement (3) ;
la saisie (S22) du second ensemble de données traité sur la position prédéterminée de l'affichage (1) à l'aide du dispositif de traitement (3) ; et
le fonctionnement (S23) du dispositif de mesure (2) sur la base du second ensemble de données traité qui a été saisi.

15. Procédé selon la revendication 14, dans lequel le procédé comprend en outre une étape d'attribution d'un préfixe et/ou d'une unité au second ensemble de données traité.
